Europäisches Patentamt

European Patent Office

Office européen des brevets

(19)

(11)     EP 0 894 766 B1

(12)     **EUROPEAN PATENT SPECIFICATION**

(45) Date of publication and mention
of the grant of the patent:
**15.09.2004  Bulletin 2004/38**

(51) Int Cl.[7]: **C01B 31/06**

(21) Application number: **98114316.7**

(22) Date of filing: **30.07.1998**

(54) **Boron-doped isotopic diamond and process for producing the same**

Bordotierter isotopischer Diamant und Verfahren zu seiner Herstellung

Diamant isotope dopé au bore et procédé de sa fabrication

(84) Designated Contracting States:
**DE FR GB**

(30) Priority: **01.08.1997  JP 22113697**
**29.11.1997  JP 34403797**

(43) Date of publication of application:
**03.02.1999  Bulletin 1999/05**

(73) Proprietors:
• **Tokyo Gas Co., Ltd.**
**Tokyo 105-8527 (JP)**
• **Tokyo Gas Chemical Co., Ltd.**
**Tokyo 163-1025 (JP)**

(72) Inventors:
• **Nakamura, Kazuo**
**Yokohama-shi, Kanagawa-ken 232-0076 (JP)**
• **Horiuchi, Kenji**
**Kawasaki-shi, Kanagawa-ken 211-0063 (JP)**
• **Yamashita, Satoshi**
**Tokyo 155-0033 (JP)**

• **Kataoka, Kazuhiro**
**Tokorozawa-shi, Saitama-ken 539-1145 (JP)**

(74) Representative: **Goddar, Heinz J., Dr. et al**
**FORRESTER & BOEHMERT**
**Pettenkoferstrasse 20-22**
**80336 München (DE)**

(56) References cited:
**GB-A- 2 257 427       GB-A- 2 278 014**

• **MASOOD A ET AL: "SYNTHESIS AND
ELECTRICAL CHARACTERIZATION OF
BORON-DOPED THIN DIAMOND FILMS"
APPLIED PHYSICS LETTERS, vol. 61, no. 15, 12
October 1992, pages 1832-1834, XP000316480**
• **PATENT ABSTRACTS OF JAPAN vol. 017, no.
638 (C-1133), 26 November 1993 & JP 05 200271
A (SUMITOMO ELECTRIC IND LTD), 10 August
1993**

## EP 0 894 766 B1

**Description**

BACKGROUND OF THE INVENTION

1. Field of the Invention

The present invention relates to a $^{12}C$ isotopic diamond or a $^{13}C$ isotopic diamond which is boron-doped and has a high thermal conductivity, and a process for producing the same. In the present specification, a diamond purified to $^{12}C$ (namely, in the isotopic ratio, the amount of $^{12}C$ in the purified diamond is increased more than that of a natural diamond) is referred to as a $^{12}C$ diamond or a $^{12}C$ isotopic diamond properly.

2. Prior Art

Since diamond has the highest hardness (Mohs hardness: 10) in known substances and an outstanding abrasion resistance, it is employed for tools such as a whetstone, an abrasive material, a die, a boring bit, a cutting tool, a coating tools and the like; in addition, since it has a high velocity of sound, it is utilized for a high-sound-generating speaker diaphragm.

Moreover, diamond has the highest thermal conductivity in all substances at room temperature, and this characteristic is exhibited more at a higher purity. Hence, it is combined into electronic parts as a heat sink material; however, since diamond is an electrical insulating material itself, it has been limited to a simple application such as said heat sink material.

A carbon or a carbon compound being present in the world of nature contains about 1.1 % of $^{13}C$ in addition to $^{12}C$, and this is also true of a natural diamond; it is known that a diamond with a carbon isotope purified has an improved thermal conductivity as compared with a diamond with a natural ratio. For example, in "Physical Review B", Vol.42, No.2, pp.1104-1111 (July 15, 1990), it is reported that a diamond with $^{12}C$ of 99.93 % is synthesized employing 99.9 % $^{12}CH_4$, and that said diamond has a thermal conductivity about 1.5 times as high as that of a diamond with a natural isotopic composition.

According to the report, a $^{12}C$ diamond singl.e crystal is synthesized as a sample thereof by preparing a diamond sheet according to the CVD method employing a 99.9 %-enriched $^{12}CH_4$, pulverizing the sheet into a powder, and growing the crystal on a small diamond seed crystal from a molten transition metal at a pressure of 52000 atm. and a temperature of 1200 °C. According to the above method of synthesis, it is necessary, first of all, to prepare a diamond powder as a carbon source according to the CVD method; however, the yield according to the CVD method is generally of the order of 1 %; hence, even if the above mateiral is employed, a process of obtaining a powder thereof is also needed in order to synthesize a diamond single crystal finally, and besides there exists a large problem on the yield thereof.

The thermal conductivity of diamond is very liable to be influenced by crystal quality, and also in the case of a $^{12}C$ isotopic diamond, if the crystal quality is poor, it is difficult to generate a high thermal conductivity according to $^{12}C$ purity; in addition, it is known that if diamond contains impurities such as nitrogen or impurities are added thereto, the thermal conductivity decreases. Japanese Patent Publication No. 4-92894 reports that a synthesized diamond with a high thermal conductivity is obtained by applying a gas phase synthesis technique, employing $^{12}C$ or $^{13}C$ wherein more than 99.9 % of carbon is carbon isotopes, and adjusting the incorporation of nitrogen to less than 20 ppm.

In addition, it is known that diamond is doped with boron to be a p-type semiconductor; a boron-doped diamond is expected to employ as a semiconductor device and a luminescent device. However, boron doped to diamond becomes an impurity to the diamond. Because of this, it has been thought to be hard that a $^{12}C$ isotopic diamond sensitive to crystal quality should express a high thermal conductivity, and this is also true of a boron-doped diamond and, needless to say, a boron-doped $^{12}C$ isotopic or $^{13}C$ isotopic diamond.

That is, it has been thought that a dopant, boron, scatters phonons, a main factor of the conduction of heat of diamond, and that, in a boron-doped and isotopically purified diamond, the improvement of thermal conductivity is small. For this point, for example, when a boron-doped diamond is applied to a semiconductor device or an optical material as an example of application, it may cause heat concentration, and it has been thought that, in such a case, an effect of a high thermal conductivity according to isotopic purity can not be utilized because of the above point.

GB-A-2 257 427 discloses an isotopically-pure $^{12}C$ or $^{13}C$ polycrystaline diamond with higher thermal conductivity than polycrystaline diamond made from natural abundance isotopes. This diamond consists of at least 99.5 weight percent isotopically pure $^{12}C$ or $^{13}C$ and is produced by a CVD method.

GB-A-2 278 014 discloses a process for producing a diamond film with high thermal conductivity comprising employing methane and hydrogen as starting materials and adding dyboren thereto to obtain a thin film of boron-doped diamond which is formed on a substrate placed in the reaction atmosphere.

JP-A-05 200 271 describes a method for producing a diamond single crystal by the temperature difference method wherein a IIb-boron-containing diamond is used as the carbon source. The melted solvent allows diffusion of the carbon from the source to form a boron-doped single crystal diamond seed at high temperature and high pressure.

SUMMARY OF THE INVENTION

However, when the present inventors actually synthesized a boron-doped and isotopically purified $^{12}$C isotopic diamond and measured the thermal conductivity thereof, they unexpectedly found that it retains the electric conductivity of a p-type semiconductor according to the additon of boron and a high thermal conductivity according to $^{12}$C purity. That is, the present invention provides a $^{12}$C or $^{13}$C isotopic diamond which is boron-doped, is isotopically purified and has a high thermal conductivity and a process for producing the same.

The present invention provides a $^{12}$C or $^{13}$C isotopic single crystal diamond as defined in claim 1 which is boron-doped, has a high thermal conductivity and is isotopically purified, and which can be used in a luminescent device or in a semiconductor device.

In addition, the present invention provides a process as defined in claim 3 for producing a $^{12}$C or $^{13}$C isotopic diamond single crystal, wherein a diamond single crystal is formed on a seed crystal diamond by using a a flake-like pyrolytic carbon comprising isotopically purified $^{12}$C or $^{13}$C as a material, employing a flux containing a nitrogen getter, adding boron into said material or the flux, or around said material and the flux, and diffusing said carbon material into the flux under a high pressure and a high temperature.

BRIEF DESCRIPTION OF THE DRAWINGS

Fig. 1 is a view showing one example of a sample constitution according to the temperature gradient method.

Fig. 2 is a view of the sample constitution employed in the present examples.

Fig. 3 is a view showing the ultrahigh-pressure device employed in the present examples.

PREFERRED EMBODIMENTS OF THE INVENTION

A $^{12}$C isotope or a $^{13}$C isotope in a diamond according to the present invention needs to have a purity (degree of isotopic purification) of at least 99.5 %, preferably at least 99.9 %, more preferably at least 99.94 %. In the present invention, a p-type semiconductor can be obtained by doping boron to an isotopically purified C isotopic diamond or $^{13}$C isotopic diamond, and said p-type semiconductor has a high thermal conductivity.

Here, the amount of boron doped is not particularly restricted so far as it is in an amount allowing a function as a p-type semiconductor to be exhibited; it is less than 100 ppm, more preferably less than 60 ppm, and according to the amount of boron added where thermal conductivity (half-band width of a Raman spectrum) begins to decrease, it is preferably of the order of 30 ppm or less.

As described above, boron doped to diamond becomes an impurity to the diamond, and hence, it has been thought to be hard that a $^{12}$C diamond sensitive to crystal quality should express a high thermal conductivity.

In the present invention, completely inversely to such a perception or technical common knowledge, a p-type semiconductor can be obtained by doping boron to an isotopic diamond comprising isotopically purified $^{12}$C or an isotopic diamond comprising isotopically purified $^{13}$C, and besides, said p-type semiconductor has a high thermal conductivity.

Hence, a boron-doped $^{12}$C diamond according to the present invention is an excellent material as a material related to heat such as a semiconductor device and a luminescent device.

Examples of a process for the production of a diamond include a gas phase method and a high-pressure method; a diamond which is boron-doped, has a high thermal conductivity and is isotopically purified according to the present invention can be produced by any one of these methods. Of them, the gas phase method comprises employing a mixed gas of a hydrocarbon gas such as methane or carbon monoxide or carbon dioxide or a mixed gas of at least two thereof and hydrogen as a material, applying a gas phase reaction, for example, the CVD method or a plasma CVD method, and forming a diamond in a thin-film state on a substrate such as a silicon wafer placed in a reaction atmosphere; a diamond according to the present invention is produced in the same manner employing these isotopically purified materials. For example, a diamond is produced by employing $^{12}CH_4$ or $^{13}CH_4$ isotopically purified to 99.5 % or more as a material and adding boranes and the like as a doping component.

Examples of the high-pressure method include a shock wave high-pressure method and a static high-pressure method, and examples of the static high-pressure method include a direct conversion method and a flux method. Of them, the direct conversion method is a method of directly converting a graphite simple substance into a diamond by applying a high temperature and a high pressure thereonto; and the flux method is a method of precipitating a diamond after dissolving a carbon into a molten metal (including alloys) such as Fe, Co and Ni. Examples of the flux method include a film growth method and a temperature gradient method. The film growth method is a method utilizing the fact that graphite and diamond have a different solubility in molten metals, wherein when a molten metal and graphite are left to come into contact with each other at a high pressure, the graphite is dissolved and diffused, and just after then (at the rear of the molten metal film) a diamond is precipitated.

On the other hand, the temperature gradient method is a method utilizing the fact that diamond has a different solubility in molten metals according to a temperature (temperature difference: about from 20 to 50 °C), wherein, to the molten metal phase heated at a high pressure, one is retained at a high temperature to dissolve a material carbon, while the other is retained at a lower temperature to precipitate a diamond. In the temperature gradient method, large grains of diamond are grown on a diamond seed crystal placed at a low temperature region, wherein the formation of spontaneous nuclei occurring is suppressed and the dissolution of the seed crystal is suppressed till the occurrence of diamond growth by arranging a diamond nucleation suppressing layer and an isolation layer at the upper part of the seed crystal.

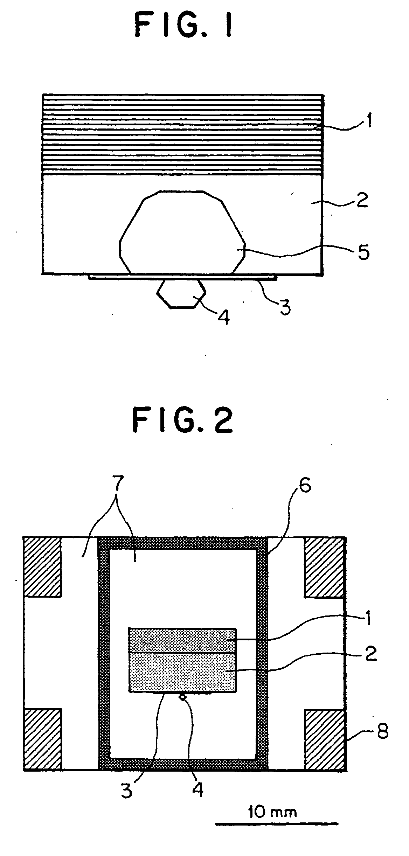

Fig. 1 shows an example about "the sample constitution" and the like introduced heretofore about the above temperature gradient method [ "Technology for Treating Resources", Vol. 37, No. 1 ( ' 90, spring), pp. 23-28]. In Fig. 1, the mark 1 shows a carbon source, the mark 2 a metal solvent, the mark 3 platinum foil, and the mark 4 a diamond seed crystal. The constitutional sample is put into a capsule of an NaCl molded article, and the capsule is packed in a cylindrical heater so that the carbon source should be at the center of the heater; in the cylindrical heater, the central part has a high temperature and both ends have a low temperature, and hence the metal solvent can have a temperature gradient according to this temperature distribution.

Subsequently, the capsule is packed in a high-pressure vessel and pressed to about 58.8 GPa (60,000 atm.), then heated to about 1400 °C and retained for from 15 to 24 hours, and thereby a crystal of from 2 to 3 mm as shown with the mark 5 in Fig. 1 is obtained; it is described that, in this case, the above platinum foil 3 is for protecting the seed crystal lest the seed crystal should be dissolved in the metal solvent to disappear at the time of the start of crystal growth. According to the above document, the platinum foil 3 is dissolved in the metal solvent to disappear gradually with time, but the metal solvent is saturated with carbon at this time, and hence the diamond seed crystal 4 is not dissolved.

In the case of synthesizing a diamond single crystal by the temperature gradient method, a diamond, graphite or a mixture thereof is employed as a carbon source. In the present invention, also in the case of producing a $^{12}$C or $^{13}$C isotopic diamond single crystal by the temperature gradient method, these carbons may be employed as a carbon source; however, a pyrolytic carbon, a diamond synthesized by chemical deposition or a diamond-like carbon synthesized by chemical deposition is preferably employed.

For example, Japanese Patent Publication No. 4-108532 suggests a technique of producing a single crystal diamond with a high isotopic purity and a high thermal conductivity by the the same temperature gradient method by preferably employing a diamond obtained by the CVD (chemical vapor deposition) method as a carbon source. Moreover, according to Japanese Patent Publication No. 5-200271, an IIb-type diamond powder containing boron as an isolated substitution-type impurity is employed as a carbon source and a diamond single crystal having semiconductor characteristics is grown by the temperature gradient method, which is related to a diamond with a natural isotopic ratio and has no consideration about thermal conductivity characteristics, and hence is different from the present invention fundamentally in these points.

In addition, a pyrolytic carbon may be employed as a carbon source; however, in this case, generally a pretreatment is indispensable. As the pretreatment is employed a technique comprising pressing, for example, a pyrolytic carbon powder, by means of a steel die, putting it in a graphite capsule, and heating it by means of an induction heating furnace under vacuum to a temperature of from 1800 to 2000 °C to anneal. However, if a flake-like pyrolytic carbon is employed as a carbon source, a single crystal diamond can be obtained without requiring such a pretreatment (Japanese Patent Publication No. 8-141385). Said flake-like pyrolytic carbon has characteristics shown in Table 1. (Table 1 describes also the characteristics of a soot-like pyrolytic carbon for comparison.)

The above flake-like pyrolytic carbon is obtained by thermally decomposing high-concentration methane, ethane, propane, benzene, acetylene, other hydrocarbon gases, or carbon monoxide (including the case of a hydrocarbon gas or carbon monoxide with a concentration of 100 % employing no carrier gas) in a furnace, for example, in the case of methane, at a decomposition temperature of from 1800 to 2000 °C and at a pressure in the furnace of from 133.3 to 666.6 Pa (1 to 5 Torr) to deposit on a substrate such as a graphite sheet and then releasing it from the substrate. In Table 1, the BAF Bacon anisotropy factor value is obtained by employing an X-ray diffraction technique, and the larger is the numerical value, the larger is the anisotropy; the BAF value of ordinary graphite is less than 2.

[Table 1]

| Kind of pyrolytic carbon | Structure by optical microscope | Density (bulk density) (g/cm$^3$) | BET* surface area (m$^2$/g) | BAF value | Lattice constant of C axis (Å) |
|---|---|---|---|---|---|
| Flake-like | Columnar | 1.10 | 3.1 | 3~20 | 6.8~7.0 |
| Soot-like | Non-columnar | 0.87 | 55.6 | about 1 | 6.8~7.0 |

*according to Brunauer-Emmett-Teller

In the present invention, in the case of employing a flake-like pyrolytic carbon as a carbon source, a diamond containing $^{12}$C or $^{13}$C at a high ratio can be produced by selecting the ratio of a carbon isotope in a material hydrocarbon gas or a material carbon monoxide, for example, the ratio of $^{12}$C or $^{13}$C in methane, at the time of producing a flake-like pyrolytic carbon, namely, by employing methane with an isotopic composition varied.

Pressure and temperature to be applied in the performance of the present invention is not particularly restricted so far as they are within the conditions of a diamond stable region; preferably, it can be performed at a pressure of from about 5 to 6.5 GPa and at a temperature of from about 1300 to 1500 °C. As a flux, any of metals or alloys (including mixtures) known as those for the flux method can be employed; preferably Fe, Co, Ni and alloys of these metals can be employed, and a component as a boron source, for example, boron, is added thereto. Moreover, a diamond containing no nitrogen as an impurity or substantially containing no nitrogen can be obtained by employing a flux containing a nitrogen getter (Ti, Zr, Al and the like) on demand.

EXAMPLES

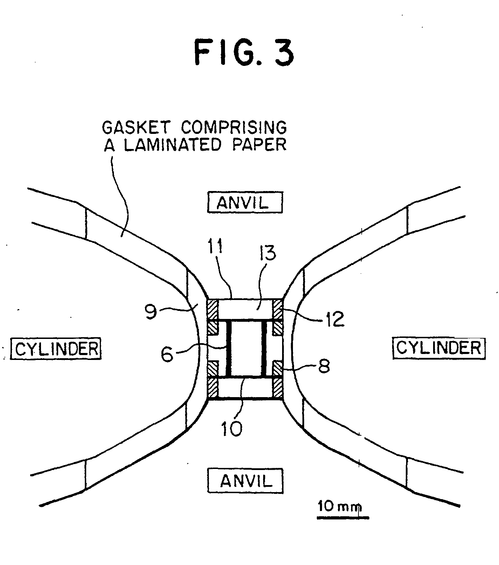

Hereafter the present invention will be described in more detail according to examples; it goes without saying that the present invention is not restricted to these examples. Here examples according to the temperature gradient method will be described, but the same can be applied to the gas phase method. Fig. 2 and Fig. 3 show the sample constitution and the ultrahigh-pressure device employed in the present examples respectively.

As shown in Fig. 2, the sample constitution is almost similar to the sample constitution shown in Fig. 1, and the same marks are used about common parts in Fig. 1 and Fig. 2. The mark 1 shows a carbon source, the mark 2 a metal solvent (= flux), the mark 3 platinum foil, and the mark 4 a diamond seed crystal. The platinum foil 3 is placed between the diamond seed crystal 4 and the flux 2, which is for preventing the seed crystal 4 from dissolving at the initial stage of production operation. In addition, the mark 6 shows a graphite heater, the mark 7 a pressure medium, and the mark 8 an iron sealing ring for sealing the pressure medium 7 provided therearound. In the present examples, a metal solvent containing a nitrogen getter was employed as the flux 2, and "NaCl + 10 wt. % ZrO$_2$" as the pressure medium 7 for transmitting pressure uniformly.

When the sample constitution (sample constituted as above) is retained under the condition where diamond is stable and under the conditions of a high temperature and a high pressure for the flux to dissolve, a diamond single crystal grows on a seed crystal; in the case of employing a cylindrical heater, the central part thereof has a relatively high temperature, and the upper and lower circumference thereof has a low temperature; hence, utilizing this nature, a temperature difference can be made between the central side (high temperature) and the lower side (low temperature) of the flux. For this, the carbon source is placed so that it should be located at the central part, namely, the high-temperature part, and thereby the material carbon at the upper side with a high temperature is dissolved in the flux and precipitated as a diamond single crystal on the seed crystal at the lower side with a low temperature.

Fig. 3 shows the cross section of a so-called flat-belt-type ultrahigh-pressure device employed in the present examples. As shown in the drawing, the device essentially comprises cylinders and anvils of an ultrahard alloy, and the mark 9 in Fig. 3 shows a gasket. The gasket 9 is for sealing pressure between the anvils and the cylinders, and in the present examples, pyrophyllite is employed as a material for it.

The sample constitution is placed between the space formed by the cylinders and the anvils as shown in Fig. 2, and heating is performed by running an electric current from the anvil to the graphite heater 6 through a stainless steel electrode 11, an electroconducting ring (iron) 12 and a molybdenum electrode 10. On the top and the bottom of the graphite heater 6 are provided zirconia plates 13 for insulation.

<<Examples>>

A diamond single crystal according to the present invention was produced by empoying the sample constitution of Fig. 2 and the ultrahigh-pressure device of Fig. 3. As a carbon source was employed a product obtained by thermally decomposing an isotopically purified $^{12}$C methane gas ($^{12}$CH$_4$, purity: more than 99.95 %) obtained from LNG (liquid natural gas) by a rectification without employing a carrier gas (namely, 100 % methane) at a decomposition treatment temperature of 1900 °C and at a pressure in the furnace of 2 Torr, depositing it on a graphite substrate and releasing it therefrom. It has a columnar structure according to an optical microscope, and has a bulk density of 1.10 g/cm$^3$, a BAF value of 5 and a BET surface area of 3.1 m$^2$/g.

Boron was added (amount of addition: 1000 ppm) to 231 mg of this flake-like pyrolytic carbon, and the mixture was employed as the carbon source 1. The above carbon source 1 was placed on the flux 2 of a metal solvent containing a nitrogen getter to form a sample constitution as shown in Fig. 2, and this sample constitution was placed in the cylinders in Fig. 3.

Thereafter, the pressure medium 7 was pressed to 6.3 GPa by upper and lower anvils. After the press, an electric current [AC, 2.69 V, 664 A (ampere)] was run to the graphite heater 6 through the stainless steel electrode 11, the electroconducting ring 12 and the molybdenum electrode 10 to heat to 1450 °C. In this case, the operation temperature was caribrated by a Pt/Pt 13 % Rh thermocouple.

After the above operation state was retained for 110 hours, the electric current was cut and then the pressing state was released to obtain a diamond single crystal. The produced diamond had a weight of 76.4 mg, and the facets on the surface of the crystal were mainly {100} and {111}. In the same manner as above, diamond single crystals were produced by employing products obtained by adding boron of 1000 ppm, 3000 ppm, 1 %, 3 % and 10 % (mol) respectively to a flake-like pyrolytic carbon obtained from a $^{12}$C methane gas as a carbon source.

⟨⟨Comparative Examples⟩⟩

In the same manner as the above technique, a non-boron-doped (namely, produced without adding boron to a carbon source) diamond with a natural isotopic ratio ($^{12}$C = 98.9 %), a boron-doped (namely, produced by adding boron to a carbon source) diamond with a natural isotopic ratio ($^{12}$C = 98.9 %), and a non-boron-doped $^{12}$C diamond ($^{12}$C = 99.95 % or more) were produced. The amount of boron and the thermal conductivity of each of the thus obtained diamonds were measured. The thermal conductivity here was measured by the following measurement 1.

<Measurement of the Amount of Boron>

Employing a microscopic Fourier transform infrared spectrometer (Janssen Micro FTIR Spectrometer, manufactured by JASCO corporation) as a device, the quantitative determination of boron was conducted according to the strength of the absorption peaks of 1280 cm$^{-1}$ and 2800 cm$^{-1}$ by boron in diamonds. The amount of boron contributing to electrical conductivity in diamonds (effective acceptor density) is determined by this method. In Table 2, the concentration of boron shows the above measured values. Table 2 also shows the amounts of boron added to the material carbon source (amounts of boron incorporated into the material).

<Measurement of Thermal Conductivity 1>

The FWHM (full width at half maximum) of a Raman peak indirectly has a correlation with thermal conductivity, as explained in W.F. Banholzer et al., "Diamond properties as a function of isotopic composition", Thin Solid Films 212 (1992), pages 1 to 10, and it is thought that, in a diamond with high crystal quality, the smaller the FWHM of a Raman peak is, the higher is the thermal conductivity suggested. The measurement of a Raman spectrum was conducted by a laser Raman spectrometer (NR-1800 model, manufactured by JASCO corporation). As a light source was employed an argon laser with a wavelength of 514.53 nm, and the output power was made 200 mW. Since the peak of a diamond appears around 1333 cm$^{-1}$, the measurement of the FWHM thereof was conducted. The resolving power in the present measurement seems to be of the order of 0.2 cm$^{-1}$ according to the measurement conditions such as a diffraction grating (1800/mm) and a slit width (20 μm).

Table 2 shows the results of the measurement. Examples 1-5 in Table 2 show typical examples of the results obtained by the above measurements.

[Table 2]

| No. | Kind of diamond | Amount of boron in carbon sorce | Concentration of boron | FWHM (full width at half maximum) of Raman peak |
|---|---|---|---|---|
| Comp. Ex.1 | Diamond with natural isotopic ratio ($^{12}$C=98.9%) | — | — | 1. 73 cm$^{-1}$ |
| Comp. Ex.2 | Diamond with natural isotopic ratio ($^{12}$C=98.9%) | 1000 ppm | 3~4 ppm | 1. 73 cm$^{-1}$ |
| Comp. Ex. 3 | Diamond with natural isotopic ratio ($^{12}$C=98.9%) | 3000 ppm | 9~19 ppm | 1. 73 cm$^{-1}$ |
| Comp. Ex.4 | $^{12}$C diamond ($^{12}$C=99.95% or more) | — | — | 1. 54 cm$^{-1}$ |
| Example 1 | $^{12}$C diamond ($^{12}$C=99.95% or more) | 1000 ppm | 3~4 ppm | 1. 54 cm$^{-1}$ |
| Example 2 | $^{12}$C diamond ($^{12}$C=99.95% or more) | 3000 ppm | 9~19 ppm | 1. 54 cm$^{-1}$ |
| Example 3 | $^{12}$C diamond ($^{12}$C=99.95% or more) | 1 % | 29~38 ppm | 1.55~1.59 cm$^{-1}$ |
| Example 4 | $^{12}$C diamond ($^{12}$C=99. 95% or more) | 3 % | 90~105 ppm | 1.57~1.70 cm$^{-1}$ |
| Example 5 | $^{12}$C diamond ($^{12}$C=99. 95% or more) | 10 % | = | 1. 88 cm$^{-1}$ |

Note

— : Nil

= : Unmeasured

As shown in Table 2, the FWHM of the Raman spectrum of comparative example, namely, the $^{12}$C diamond ($^{12}$C = 99.95 % or more), is 1.54 cm$^{-1}$, which corresponds to a thermal conductivity of about 31 W/cm K. In contrast, all of the $^{12}$C diamond ($^{12}$C = 99.95 % or more) of example 1, the $^{12}$C diamond ($^{12}$C = 99.95 % or more) of example 2 and the $^{12}$C diamond ($^{12}$C = 99.95 % or more) of example 3 show the equal FWHM of Raman peak as the above $^{12}$C diamond of comparative example 4 and have a high thermal conductivity. Boron is an impurity to diamond and decreases thermal conductivity according to conventional technical common knowledge; however, the present invention shows that doping of boron has no influence upon thermal conductivity.

<Measurement of Thermal Conductivity 2>

The measurement according to the FWHM of a Raman peak in the above measurement 2 is an indirect method, but the present measurement 2 is a direct method. As a device was employed a steady-state high thermal conductivity measurement device (TS/Lλ-8550, manufactured by Rigaku). As a sample was employed each diamond of 2 x 0. 3 x 3 mm obtained in the above process of production. Both ends of a diamond sample were held by a golden probe (2 x 2 x 8 mm), and a temperature difference was provided on both ends of the probe. It was retained under vacuum till it reached at steady state, and temperature gradients of the sample and the probes coated with a graphite paste in advance were measured by an infrared detector.

The thermal conductivity ($\lambda_{Sample}$) of the sample was calculated by the formula below according to the temperature gradient of the sample and that of the golden probe. In the formula (1), $\lambda_{Au}$ denotes the thermal conductivity of the golden probe, $(dT/dL)_{Au}$ and $(dT/dL)Sample$ denote the temperature gradient of the golden probe and that of the sample respectively, and $A_{Au}$ and $A_{Sample}$ denote the sectional area of the golden probe and that of the sample respectively. Table 3 shows typical examples of the thus obtained results.

The present measurement of thermal conductivity is conducted when the temperature of the sample is about 36 °C, and since the scattering of phonons which interfere with the conduction of heat is smaller at a lower temperature, the measured value of thermal conductivity at room temperature is guessed to be higher.

[Formula 1]

$$\lambda_{Sample} = \frac{A_{Au}}{A_{Sample}} \cdot \frac{\left(\dfrac{dT}{dL}\right)_{Au}}{\left(\dfrac{dT}{dL}\right)_{Sample}} \cdot \lambda_{Au} \qquad (1)$$

[Table 3]

| No. | Kind of diamond | $^{12}$C isotopic ratio | Doping | Thermal conductivity (W/cm K) | Electrical characteristic |
|---|---|---|---|---|---|
| 1 | Diamond with natural isotopic ratio | 98.9 % | Nil | 22.3 | Insulator |
| 2 | " | " | " | 22.9 | " |
| 3 | " | " | " | 22.6 | " |
| 4 | $^{12}$C diamond | ≧99.95 % | Nil | 31.8 | Insulator |
| 5 | " | " | " | 31.8 | " |
| 6 | " | " | " | 29.9 | " |
| 7 | Diamond with natural isotopic ratio containing boron | 98.9 % | Boron = 3~4 ppm | 23.9 | p-type semiconductor |
| 8 | $^{12}$C diamond containing boron | ≧99.95 % | Boron = 3~4 ppm | 30.6 | p-type semiconductor |
| 9 | " | " | Boron = 30~40 ppm | 28.0 | " |

As is apparent from Table 3, the diamond with a natural isotopic ratio containing no boron is an insulater for its electrical characteristic, and exhibits a thermal-conductive characteristic of a thermal conductivity of about 23 W/cm K. The diamond with a natural isotopic ratio containing boron is a p-type semiconductor for its electrical characteristic, and the thermal conductivity thereof is about 24 W/cm K.

In contrast, the $^{12}$C purified diamond ($^{12}$C isotope ≧ 99.95 %) containing boron of from 3 to 4 ppm is a p-type semiconductor and exhibits a thermal-conductive characteristic of a thermal conductivity of about 31 W/cm K; and the same $^{12}$C purified diamond, which contains boron of from 30 to 40 ppm, exhibits an excellent value of a thermal conductivity of about 28 W/cm K. The reason why the amount of boron doped ranges from 30 to 40 ppm is that boron was distributed in the sample within this range.

According to the present invention, a $^{12}$C or $^{13}$C isotopic diamond which is boron-doped and has an extremely high thermal conductivity can be obtained. Said $^{12}$C isotopic diamond or $^{13}$C isotopic diamond which is boron-doped and has a high thermal conductivity is an excellent material as a material related to heat such as a semiconductor device and a luminescent device.

The features disclosed in the foregoing description, in the claims and/or in the accompanying drawings may, both separately and in any combination thereof, be material for realising the invention in diverse forms thereof.

**Claims**

1. A single crystal diamond having a boron content, **characterized in that** the boron content is in a concentration of up to 100 ppm and the diamond is at least 99,5% isotopically pure $^{12}$C or $^{13}$C.

2. Use of a single crystal diamond according to claim 1 in a semiconductor device or a luminescent device:

3. Process for producing a single crystal diamond containing boron comprising the steps of

   - dissolving a carbon source in a metal solvent (2) containing a nitrogen getter and
   - using a seed crystal for precipitating the single crystal diamond,

   **characterized in that** the carbon source is a flake-like pyrolytic carbon (1) having a content of either $^{12}$C isotope or $^{13}$C isotope of at least 99.5 % and boron is added to the flake-like pyrolytic carbon and/or the molten metal, whereby the diamond is doped with boron in the range of up to 100 ppm.

4. Process according to claim 3, **characterized in that** the diamond is precipitated at a side of the metal solvent (2) having a lower temperature than a side of the metal solvent (2) having a higher temperature.

5. Process according to one of the claims 3 and 4, **characterized in that** the single crystal diamond precipitates from the metal solvent (2), in which it is retained under such conditions of high temperature and high pressure to be in a dissolved state.

6. Process according to one of the claims 3 to 5, **characterized in that** the flake-like pyrolytic carbon is obtained from pyrolytic carbon powder by a process comprising pressing by means of a steel die, introducing it into a graphite capsule and heating it in an induction heating furnace under vacuum to a temperature of 1.800 to 2.000° C to anneal.

7. Process according to one of the claims 3 to 6, **characterized in that** the diamond is doped with boron in the range of up to 60 ppm.

8. Process according to one of the claims 3 to 7, **characterized in that** the diamond is doped with boron in the range of up to 30 ppm.

9. Use of a process for producing single crystal diamonds according to one of the claims 3 to 8 for the production of p-type semiconductors.

**Patentansprüche**

1. Einkristalldiamant mit einem Borgehalt, **dadurch gekennzeichnet, dass** der Borgehalt in einer Konzentration bis zu 100 ppm vorliegt und der Diamant wenigstens 99,5 % isotopisch reines $^{12}$C oder $^{13}$C ist.

2. Verwendung eines Einkristalldiamanten nach Anspruch 1 in einer Halbleitervorrichtung oder in einer Lumineszenzvorrichtung.

3. Verfahren zum Herstellen eines Einkristalldiamanten, welcher Bor enthält, das die Schritte aufweist

   - Lösen einer Kohlenstoffquelle in einem metallischen Lösemittel (2), welches einen Stickstoff-Getter enthält und

   - Verwenden eines Keimkristalls zum Ausfällen des Einkristalldiamanten,

   **dadurch gekennzeichnet, dass** die Kohlenstoffquelle ein flockenartiger pyrolytischer Kohlenstoff (1) ist, der einen Gehalt an entweder $^{12}$C-Isotop oder $^{13}$C-Isotop von wenigstens 99,5 % hat, und Bor zu dem flockenartigen pyrolytischen Kohlenstoff und/oder dem geschmolzenen Metall hinzugefügt wird, wodurch die Diamant mit Bor in dem Bereich bis zu 100 ppm dotiert wird.

4. Verfahren nach Anspruch 3, **dadurch gekennzeichnet, dass** der Diamant an einer Seite des metallischen Lösungsmittels (2) mit einer niedrigeren Temperatur als einer Seite des metallischen Lösungsmittels (2) mit einer höheren Temperatur ausgefällt wird.

**5.** Verfahren nach einem der Ansprüche 3 und 4, **dadurch gekennzeichnet, dass** der Einkristalldiamant aus dem metallischen Lösungsmittel (2) ausfällt, indem er unter solchen Bedingungen hoher Temperatur und hohen Druckes gehalten wird, dass er in einem gelösten Zustand ist.

**6.** Verfahren nach einem der Ansprüche 3 bis 5, **dadurch gekennzeichnet, dass** der flockenartige pyrolytische aus pyrolytischem Kohlenstoffpulver durch einen Prozess erhalten wird, der das Pressen mittels eines Stahlpresswerkzeuges, des Einführens desselben in einer Graphitkapsel und des Erhitzens desselben in einem Induktionsheizofen unter Vakuum auf eine Temperatur von 1800 bis 2000° zum Glühen aufweist.

**7.** Verfahren nach einem der Ansprüche 3 bis 6, **dadurch gekennzeichnet, dass** der Diamant mit Bor in dem Bereich bis zu 60 ppm dotiert ist.

**8.** Prozess nach einem der Ansprüche 3 bis 7, **dadurch gekennzeichnet, dass** der Diamant mit Bor in dem Bereich bis zu 30 ppm dotiert ist.

**9.** Verwendung eines Verfahrens zum Herstellen von Einkristalldiamanten nach einem der Ansprüche 3 bis 8 für die Erzeugung von Halbleitern vom p-Typ.

**Revendications**

**1.** Diamant monocristallin contenant du bore, **caractérisé en ce que** la teneur en bore est à une concentration pouvant aller jusqu'à 100 ppm et **en ce que** le diamant est un isotope $^{12}$C ou $^{13}$C ayant une pureté d'au moins 99,5 %.

**2.** Utilisation d'un diamant monocristallin selon la revendication 1 dans un dispositif semi-conducteur ou un dispositif luminescent.

**3.** Procédé de production d'un diamant monocristallin contenant du bore, comprenant les étapes consistant à :

- dissoudre une source de carbone dans un métal solvant (2) contenant un capteur d'azote et
- utiliser un germe cristallin pour précipiter le diamant monocristallin,

**caractérisé en ce que** la source de carbone est un carbone pyrolytique de type flocons (1) ayant une teneur en isotope $^{12}$C ou en isotope $^{13}$C d'au moins 99,5 %, et **en ce que** le bore est ajouté au carbone pyrolytique de type flocons et/ou au métal fondu, le diamant étant ainsi dopé avec du bore dans une plage allant jusqu'à 100 ppm.

**4.** Procédé selon la revendication 3, **caractérisé en ce que** le diamant est précipité du côté du métal solvant (2) ayant une température plus basse que celle du côté du métal solvant (2) ayant une température plus élevée.

**5.** Procédé selon l'une quelconque des revendications 3 et 4, **caractérisé en ce que** le diamant monocristallin précipite à partir du métal solvant (2), dans lequel il est retenu dans des conditions de température élevée et de pression élevée telles qu'il se trouve à l'état dissous.

**6.** Procédé selon l'une quelconque des revendications 3 à 5, **caractérisé en ce que** le carbone pyrolytique de type flocons est obtenu à partir d'une poudre de carbone pyrolytique par un procédé consistant à la compacter au moyen d'une filière en acier, à l'introduire dans une capsule en graphite et à la chauffer dans un four à chauffage par induction sous vide jusqu'à une température de 1800 à 2000°C pour obtenir un recuit.

**7.** Procédé selon l'une des revendications 3 à 6, **caractérisé en ce que** le diamant est dopé avec du bore dans une plage allant jusqu'à 60 ppm.

**8.** Procédé selon l'une des revendications 3 à 7, **caractérisé en ce que** le diamant est dopé avec du bore dans une plage allant jusqu'à 30 ppm.

**9.** Utilisation d'un procédé de production de diamants monocristallins selon l'une quelconque des revendications 3 à 8 pour la production de semiconducteurs de type p.

EP 0 894 766 B1

# FIG. 1

# FIG. 2

10 mm

11

# FIG. 3

GASKET COMPRISING
A LAMINATED PAPER

ANVIL

11    13

9        12

CYLINDER

6        8

CYLINDER

10

ANVIL

10 mm